# EUROPEAN PATENT APPLICATION

(11) **EP 2 846 395 A2**
(43) Date of publication of application: **11.03.2015**
(21) Application number: 14183723.7
(22) Date of filing: 05.09.2014
(51) Int. Cl.: H01M 10/48, H01M 10/42

(54) **Battery pack, apparatus including battery pack, and method of managing battery pack**

(30) Priority: 09.09.2013 KR 20130108056
(71) Applicant: Samsung SDI Co., Ltd., Yongin-si, Gyeonggi-do (KR)
(72) Inventor: Kim, Jong-Hoon, Yongin-si, Gyeonggi-do (KR); Nikitenkov, Dmitry, Yongin-si, Gyeonggi-do (KR); Park, Jung-Pil, Yongin-si, Gyeonggi-do (KR)
(74) Representative: Gulde & Partner

(57) **Abstract**

A battery pack including a battery coupled to a load and a charging device, and comprising at least one battery cell, and a battery management unit for controlling charging of the battery from the charging device and discharging of the battery to the load, wherein the battery management unit includes a measuring unit for generating cell voltage data and current data by measuring a cell voltage and a current of the at least one battery cell, a capacity estimating unit for generating current capacity data based on the cell voltage data and the current data, an internal resistance estimating unit for generating current internal resistance data based on the cell voltage data and the current data, and a state of health (SOH) estimating unit for estimating an SOH of the at least one battery cell based on the current capacity data and the current internal resistance data.

## Description

### BACKGROUND

### 1. Field

One or more embodiments of the present invention relate to a battery pack, an apparatus including the battery pack, and a method of managing the battery pack, and more particularly, to a battery pack including a battery cell, an apparatus including the battery pack, and a method of managing the battery pack by estimating a state of health (SOH) of the battery cell.

### 2. Description of the Related Art

Unlike a primary battery that is not designed to be recharged, a secondary battery can be repeatedly charged and discharged, and is widely used not only in high-tech small electronic devices including smartphones, notebook computers, person digital assistants (PDAs), or the like, but also used in electric vehicles and energy storage systems. The battery capacity is decreased according to a use environment, a use period, the number of charging and discharging, and/or the like. A state of health (SOH) of a battery is an index for indicating how much the battery capacity is decreased compared to its initial battery capacity stated in its specification, and is one of the key parameters for evaluating the battery.

In order to estimate the SOH of the battery, a current calculation method may be used. The current calculation method involves estimating a battery capacity by fully charging and discharging the battery, and estimating the SOH of the battery by comparing the battery capacity with the initial battery capacity. If temperature variation or charging speed variation can be appropriately compensated, the current calculation method may accurately estimate the SOH of the battery. However, because the battery has to be fully charged and then fully discharged, the current calculation method is not efficient (e.g., is time consuming). Alternatively, the SOH of the battery may be estimated by measuring impedance of the battery. In order to measure the impedance of the battery, an alternating voltage response of the battery has to be measured. However, the impedance measurement method requires an additional circuit, and is not efficient (e.g., may not be desirable) due to sensor errors, durability, costs, and/or the like.

### SUMMARY

One or more aspects according to embodiments of the present invention include a battery pack having a battery cell whose state of health (SOH) may be estimated in real-time, and an apparatus including the battery pack.

One or more aspects according to embodiments of the present invention include a method of managing a battery pack by easily estimating an SOH of a battery cell in real-time.

Additional aspects will be set forth in part in the description that follows and, in part, will be apparent from the description, or may be learned by practice of the presented embodiments.

According to an aspect of embodiments according to the present invention, there is provided a battery pack including: a battery coupled to a load and a charging device, and including at least one battery cell; and a battery management unit configured to control charging of the battery from the charging device and discharging of the battery to the load, wherein the battery management unit includes: a measuring unit configured to generate cell voltage data and current data by measuring a cell voltage and a current of the at least one battery cell; a capacity estimating unit configured to generate current capacity data by estimating a current capacity of the at least one battery cell based on the cell voltage data and the current data; an internal resistance estimating unit configured to generate current internal resistance data by estimating a current internal resistance of the at least one battery cell based on the cell voltage data and the current data; and a state of health (SOH) estimating unit configured to estimate an SOH of the at least one battery cell based on the current capacity data and the current internal resistance data.

The battery pack may further include a first storage unit for storing first data on a correlation between an open circuit voltage and a state of charge (SOC) of the at least one battery cell.

The capacity estimating unit may be configured to: store a first open circuit voltage that is a cell voltage of the at least one battery cell at a first time when the current of the at least one battery cell is 0; store a second open circuit voltage that is a cell voltage of the at least one battery cell at a second time when the current of the at least one battery cell is 0; calculate a varied capacity between the first time and the second time by integrating the current of the at least one battery cell from the first time to the second time; obtain a first SOC corresponding to the first open circuit voltage and a second SOC corresponding to the second open circuit voltage, based on the first data; and measure the current capacity of the at least one battery cell by dividing the varied capacity by a difference between the first SOC and the second SOC, and updates the current capacity data.

The first time and the second time may be set such that the difference between the first SOC and the second SOC may be equal to or greater than 36%.

The internal resistance estimating unit may be configured to: store a charging-discharging voltage that is a cell voltage of the at least one battery cell at a third time when the current of the at least one battery cell is not 0; store charging-discharging current that is the current of the at least one battery cell at the third time; obtain an open circuit voltage of the at least one battery cell corresponding to an SOC of the at least one battery cell at the third time, based on the first data; and estimate the current internal resistance of the at least one battery cell by dividing a difference between the open circuit voltage and the charging-discharging voltage by the charging-discharging current; and update the current internal resistance data based on the estimated current internal resistance of the at least one battery cell.

The internal resistance estimating unit may be configured to: store a third open circuit voltage that is a cell voltage of the at least one battery cell at a fourth time when current of the at least one battery cell is 0; and estimate the current internal resistance of the at least one battery cell by dividing a difference between a cell voltage of the at least one battery cell at a fifth time, near the fourth time, when current of the at least one battery cell is not 0 and the third open circuit voltage by current of the at least one battery cell at the fifth time; and update the current internal resistance data based on the estimated current internal resistance of the at least one battery cell.

The battery pack may further include a second storage unit for storing initial capacity data on an initial capacity of the at least one battery cell and initial internal resistance data on an initial internal resistance of the at least one battery cell.

The SOH estimating unit may be configured to measure a first SOH of the at least one battery cell, based on the initial capacity data and the current capacity data.

The SOH estimating unit may include deterioration capacity data on a deterioration capacity of the at least one battery cell when the at least one battery cell is in a deterioration state, and wherein the first SOH may be calculated by dividing a difference between the current capacity and the deterioration capacity of the at least one battery cell by a difference between the initial capacity and the deterioration capacity of the at least one battery cell.

The SOH estimating unit may be configured to estimate a second SOH of the at least one battery cell based on the initial internal resistance data and the current internal resistance data.

The SOH estimating unit may include deterioration internal resistance data on a deterioration internal resistance of the at least one battery cell when the at least one battery cell is in a deterioration state, and wherein the second SOH may be calculated by dividing a difference between the deterioration internal resistance and the current internal resistance of the at least one battery cell by a difference between the deterioration internal resistance and the initial internal resistance of the at least one battery cell.

The SOH estimating unit may be configured to: estimate a first SOH of the at least one battery cell, based on the initial capacity data and the current capacity data; estimate a second SOH of the at least one battery cell, based on the initial internal resistance data and the current internal resistance data; and estimate the SOH of the at least one battery cell, based on the first SOH and the second SOH.

The SOH may be estimated as an average of the first SOH and the second SOH.

According to another aspect of embodiments according to the present invention, there is provided a device including: a battery pack including a battery and a battery management unit configured to control charging and discharging of the battery, the battery including at least one battery cell; a measuring unit configured to generate cell voltage data and current data by measuring a cell voltage and a current of the at least one battery cell; a capacity estimating unit configured to generate current capacity data by estimating a current capacity of the at least one battery cell based on the cell voltage data and the current data; an internal resistance estimating unit configured to generate current internal resistance data by estimating a current internal resistance of the at least one battery cell based on the cell voltage data and the current data; and a state of health (SOH) estimating unit configured to estimate an SOH of the at least one battery cell based on the current capacity data and the current internal resistance data.

The device may be an energy storage device including a power conversion device coupled between the battery pack and at least one of a power generation system, a load, and a grid, wherein the power conversion device may be configured to convert electric energy between the battery pack and at least one of the power generation system, the load, and the grid.

The device may include an electric vehicle including the battery pack and a motor, wherein the motor may be driven by using electric energy stored in the battery pack.

According to another aspect of embodiments according to the present invention, there is provided a method of managing a battery pack including a battery and a battery management unit for controlling charging and discharging of the battery, the battery including at least one battery cell, the method including: generating cell voltage data and current data by measuring a cell voltage and a current of the at least one battery cell; generating current capacity data by estimating a current capacity of the at least one battery cell based on the cell voltage data and the current data; generating current internal resistance data by estimating a current internal resistance of the at least one battery cell based on the cell voltage data and the current data; and estimating a state of health (SOH) of the at least one battery cell based on the current capacity data and the current internal resistance data.

The method may further include storing first data on a correlation between an open circuit voltage and a state of charge (SOC)of the at least one battery cell, wherein the generating of the current capacity data may include: obtaining a first open circuit voltage that is a cell voltage of the at least one battery cell at a first time when the current of the at least one battery cell is 0; obtaining a second open circuit voltage that is a cell voltage of the at least one battery cell at a second time when the current of the at least one battery cell is 0; calculating a varied capacity between the first time and the second time by integrating the current of the at least one battery cell from the first time to the second time; obtaining a first SOC corresponding to the first open circuit voltage and a second SOC corresponding to the second open circuit voltage, based on the first data; and estimating the current capacity of the at least one battery cell by dividing the varied capacity by a difference between the first SOC and the second SOC.

The method may further include storing first data on a correlation between an open circuit voltage and a state of charge (SOC)of the at least one battery cell, wherein the generating of the current internal resistance data may include: storing a charging-discharging voltage that is a cell voltage of the at least one battery cell at a third time when the current of the at least one battery cell is not 0; storing charging-discharging current that is the current of the at least one battery cell at the third time; obtaining an open circuit voltage of the at least one battery cell corresponding to an SOC of the at least one battery cell at the third time, based on the first data; and estimating the current internal resistance of the at least one battery cell by dividing a difference between the open circuit voltage and the charging-discharging voltage by the charging-discharging current.

The estimating of the SOH may include: estimating a first SOH of the at least one battery cell, based on initial capacity data on an initial capacity of the at least one battery cell and the current capacity data; estimating a second SOH of the at least one battery cell, based on initial internal resistance data on an initial internal resistance of the at least one battery cell and the current internal resistance data; and estimating the SOH of the at least one battery cell, based on the first SOH and the second SOH.

### BRIEF DESCRIPTION OF THE DRAWINGS

The above and/or other aspects of the present invention will become apparent and more readily appreciated from the following description of the embodiments, taken in conjunction with the accompanying drawings of which:
FIG. 1 is a block diagram of a battery pack, according to an example embodiment of the present invention;
FIG. 2 is a block diagram of a battery pack, according to another example embodiment of the present invention;
FIG. 3A illustrates graphs indicating a voltage, current, and a remaining capacity of a battery cell, according to an example embodiment of the present invention;
FIG. 3B illustrates a graph indicating a correlation between an open circuit voltage and a state of charge (SOC) of the battery cell according to an example embodiment of the present invention;
FIG. 4 illustrates a graph of an SOH estimated according to the one or more example embodiments and an SOH estimated according to a comparative example;
FIG. 5 is a block diagram of an energy storage device including a battery pack, according to an example embodiment of the present invention; and
FIG. 6 is a block diagram of an electric vehicle including a battery pack, according to an example embodiment of the present invention.

### DETAILED DESCRIPTION

Reference will now be made in detail to embodiments, examples of which are illustrated in the accompanying drawings, wherein like reference numerals refer to the like elements throughout. In this regard, the present embodiments may have different forms..

Like reference numerals in the drawings denote like elements. In the drawings, the dimension of structures may be exaggerated for clarity.

Furthermore, all examples and conditional language recited herein are to be construed as being without limitation to such specifically recited examples and conditions. Throughout the specification, a singular form may include plural forms, unless there is a particular description contrary thereto. Also, terms such as "include," "including," "comprise," or "comprising" are used to specify existence of a recited form, a number, a process, an operation, a component, and/or groups thereof, not excluding the existence of one or more other recited forms, one or more other numbers, one or more other processes, one or more other operations, one or more other components and/or groups thereof. As used herein, the term "and/or" includes any and all combinations of one or more of the associated listed items. Throughout the specification, while terms "first" and "second" are used to describe various components, it is intended that the components not be limited to the terms "first" and "second". The terms "first" and "second" are used only to distinguish between each component. Throughout the specification, it will also be understood that when an element is referred to as being "on" another element, it can be directly on the other element, or intervening elements may also be present.

Unless expressly described otherwise, all terms including descriptive or technical terms, which are used herein, should be construed as having meanings that are obvious to one of ordinary skill in the art. Also, terms that are defined in a general dictionary and that are used in the following description should be construed as having meanings that are equivalent to meanings used in the related description, and unless expressly described otherwise herein, the terms should not be construed as being ideal or excessively formal.

Expressions such as "at least one of," when preceding a list of elements, modify the entire list of elements and do not modify the individual elements of the list.

Herein, the use of the term "may," when describing embodiments of the present invention, refers to "one or more embodiments of the present invention." In addition, the use of alternative language, such as "or," when describing embodiments of the present invention, refers to "one or more embodiments of the present invention" for each corresponding item listed.

The term "time" refers to a brief moment of time, and throughout the specification, each of the "first time" and the "second time" may refer to a brief moment of time or may refer to a time period. For example, the first time may refer to a first time period having a temporal length (e.g., a predetermined temporal length) and the second time may refer to a second time period that does not overlap with the first time period.

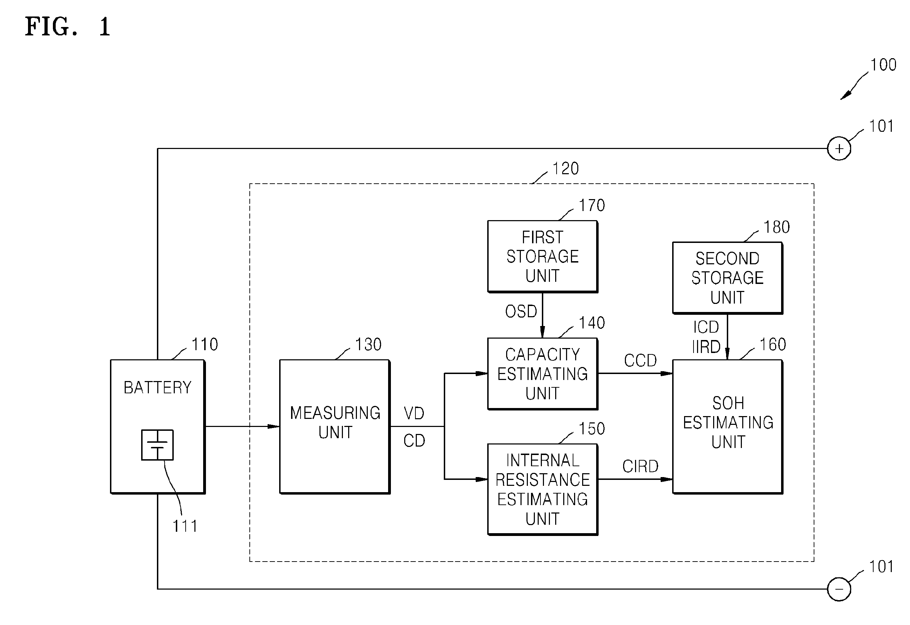

FIG. 1 is a block diagram of a battery pack 100, according to an embodiment of the present invention.

Referring to FIG. 1, the battery pack 100 includes a battery 110 and a battery management unit 120. The battery management unit 120 includes a measuring unit 130, a capacity estimating unit 140, an internal resistance estimating unit 150, and a state of health (SOH) estimating unit 160.

The battery 110 stores power and includes at least one battery cell 111. The battery 110 may include a plurality of the battery cells 111 that are connected in series, in parallel, or in combination of serial and parallel connections. The number of the battery cells 111 included in the battery 110 may be determined according to a desired output voltage.

The battery 110 may be connected to a load and a charging device via terminals 101. When the battery 110 is discharged, the battery 110 outputs electric energy to the load via the terminals 101, and when the battery 110 is charged, the battery 110 stores electric energy input from the charging device via the terminals 101. In an example where the battery pack 100 is mounted in a pure electric vehicle that is driven by only electric energy or in a hybrid electric vehicle that is driven by electric energy or fossil fuel, the load may be a driving motor of the electric vehicle, and the charging device may be an electric vehicle charger and a regenerative generator that generates power by regenerating energy that occurs in braking.

When the battery pack 100 and a power conversion device make up an energy storage device, wherein the power conversion device is electrically coupled to (e.g., connected among) a generating system, the battery pack 100, a load, and/or a grid, and converts electric energy therebetween, the load may be the load and/or the grid, and the charging device may be the generating system and/or the grid.

The battery cell 111 may include a chargeable secondary battery. For example, in one embodiment, the battery cell 111 includes a nickel-cadmium battery, a lead storage battery, a nickel metal hydride battery (NiMH), a lithium ion battery, a lithium polymer battery, and/or the like.

The battery 110 may be formed of a plurality of battery modules that may include the battery cells 111 connected in series, in parallel, or in any suitable combination of serial and parallel connections.

The battery management unit 120 monitors a state of the battery 110 and controls all operations including charging and discharging operations by the battery 110. The battery management unit 120 may be referred to as a battery management system (BMS).

The battery management unit 120 may measure parameters, such as cell voltage, temperature, charging and discharging currents, and/or the like, that are related to the battery 110, and may control charging and discharging of the battery 110, based on data of the measured parameters. The battery management unit 120 may calculate a remaining amount of power, a lifetime, a state of charge (SOC) (measured, e.g., as a percentage of the fully charged state), and/or the like from the data or may determine whether or not an error has occurred in the battery 110. For example, the battery management unit 120 may determine whether or not an error such as over-charging, over-discharging, over-current, an over-voltage, overheating, a battery cell imbalance, battery cell deterioration, and/or the like has occurred. If an error has occurred, the battery management unit 120 may perform a suitable operation (e.g., a preset operation) according to an internal algorithm. For example, the battery management unit 120 may control a charging switch and/or a discharging switch, or may cut a fuse. The battery management unit 120 may control a cell balancing operation by battery cells of the battery 110 according to the data and a suitable algorithm (e.g., a preset algorithm).

The battery management unit 120 includes the measuring unit 130 for generating cell voltage data VD and current data CD by measuring a cell voltage and current of the battery cell 111; the capacity estimating unit 140 for generating current capacity data CCD by estimating a current capacity of the battery cell 111 based on the cell voltage data VD and the current data CD; the internal resistance estimating unit 150 for generating current internal resistance data CIRD by estimating a current internal resistance of the battery cell 111 based on the cell voltage data VD and the current data CD; and the SOH estimating unit 160 for estimating an SOH of the battery cell 111 based on the current capacity data CCD and the current internal resistance data CIRD. Although the measuring unit 130, the capacity estimating unit 140, the internal resistance estimating unit 150, and the SOH estimating unit 160 are illustrated as separate elements, the measuring unit 130, the capacity estimating unit 140, the internal resistance estimating unit 150, and the SOH estimating unit 160 may be included (e.g., embodied) in one chip. In another embodiment, the measuring unit 130 may be included in a device called an analog front end (AFE), and the capacity estimating unit 140, the internal resistance estimating unit 150, and the SOH estimating unit 160 may be included in a microcontroller called a battery monitoring unit (BMU).

The measuring unit 130 generates the cell voltage data VD by measuring the cell voltage of the battery cell 111. The measuring unit 130 is coupled to (e.g., connected to) both terminals of the battery cell 111 via lines and thus may directly measure the cell voltage of the battery cell 111. The measuring unit 130 may include an analog to digital converter (ADC) so as to convert the measured cell voltage into the cell voltage data VD. In an embodiment, the measuring unit 130 may be coupled to nodes between the battery cells 111 via lines, and may generate a plurality of pieces of cell voltage data VD that correspond to cell voltages of the battery cells 111. In consideration of cell voltage variation, a noise, and a measurement tolerance, the cell voltage data VD may correspond to an average of cell voltage values of the battery cell 111 during a time (e.g., a predetermined time). The time may be 1 second, 10 seconds, or 1 minute long.

The measuring unit 130 generates the current data CD by measuring the charging current and the discharging current of the battery cell 111. The measuring unit 130 may measure the charging current and the discharging current of the battery cell 111 by using a current sensor. In an example in which the battery cells 111 are connected in series, the same amplitude of current flows in the battery cells 111 that are connected in series, thus, the measuring unit 130 may measure only one current with respect to the battery cells 111. In an example in which the battery cells 111 are connected in parallel or are connected in series and parallel, the measuring unit 130 may measure cell current of each of the battery cells 111 or may measure cell current of each of the battery cells 111 that are connected in parallel. The measuring unit 130 may include an ADC so as to convert the measured current into the current data CD. In consideration of cell voltage variations, noise, and measurement tolerances, the current data CD may correspond to an average of current values of the battery cell 111 during a time (e.g., a predetermined time). The time may be 1 second, 10 seconds, or 1 minute long.

The measuring unit 130 may further measure parameters such as a temperature of the battery 110, a terminal voltage, the cell voltage, the charging current, the discharging current of the battery cell 111, and/or the like.

The capacity estimating unit 140 generates the current capacity data CCD by estimating the current capacity of the battery cell 111 based on the cell voltage data VD and the current data CD. The capacity estimating unit 140 may receive the cell voltage data VD and the current data CD from the measuring unit 130, and may estimate the current capacity of the battery cell 111 by using the cell voltage data VD and the current data CD.

In an embodiment, the capacity estimating unit 140 determines a fully-charged state and a fully-discharged state by using the cell voltage data VD, and integrates current that flows into or flows out of the battery cell 111 between the fully-charged state and the fully-discharged state by using the current data CD, so that the capacity estimating unit 140 may calculate a full charging capacity or a full discharging capacity.

In another embodiment, the capacity estimating unit 140 estimates the current capacity of the battery cell 111 by using data OSD on a correlation between the open circuit voltage and the SOC of the battery cell 111. The battery management unit 120 may further include a first storage unit 170 that stores the data OSD. The open circuit voltage of the battery cell 111 is a cell voltage at which a load or a charging device is not coupled to (e.g., connected to) the battery cell 111, and is equal to a cell voltage at which current of the battery cell 111 is 0. The SOC of the battery cell 111 indicates a ratio of a capacity of the battery cell 111 to a remaining capacity of the battery cell 111.

The capacity estimating unit 140 may determine a first time at which current of the battery cell 111 is 0, based on the cell voltage data VD and the current data CD, and may determine a first open circuit voltage that is a cell voltage of the battery cell 111 at the first time.

The capacity estimating unit 140 may determine a second time at which current of the battery cell 111 is 0, based on the cell voltage data VD and the current data CD, and may determine a second open circuit voltage that is a cell voltage of the battery cell 111 at the second time. The second time may be different from the first time. Additionally, the second open circuit voltage may be different from the first open circuit voltage.

The capacity estimating unit 140 may integrate current between the first time and the second time, based on the cell voltage data VD and the current data CD, and then may calculate a varied capacity of the battery cell 111 between the first time and the second time, i.e., a varied amount of the remaining capacity of the battery cell 111. The varied capacity indicates a difference between the remaining capacity of the battery cell 111 at the first time and the remaining capacity of the battery cell 111 at the second time.

The capacity estimating unit 140 may determine a first SOC corresponding to the first open circuit voltage and a second SOC corresponding to the second open circuit voltage, based on the data OSD. For example, the first SOC indicates an SOC of the battery cell 111 at the first time, and the second SOC indicates an SOC of the battery cell 111 at the second time. In general, the first and second SOCs may be expressed as actual numbers between 0 and 1 or may be expressed in a percentage.

The capacity estimating unit 140 may measure the current capacity of the battery cell 111 by dividing the varied capacity by a difference between the first SOC and the second SOC. For example, when the first SOC is 90% and the second SOC is 40%, if the remaining capacity of the battery cell 111 is decreased by 1000mAh between the first time and the second time, the current capacity of the battery cell 111 may be estimated as 2000mAh. As another example, when the first SOC is 30% and the second SOC is 90%, if the remaining capacity of the battery cell 111 is increased by 1500mAh between the first time and the second time, the current capacity of the battery cell 111 may be estimated as 2500mAh. In the aforementioned examples, each of 1000mAh and 1500mAh may correspond to the varied capacity of the battery cell 111, and may be calculated by integrating current of the battery cell 111 between the first time and the second time, based on the current data CD.

The capacity estimating unit 140 may update the current capacity data CCD by referring to the estimated current capacity. For example, when the estimated current capacity is 2000mAh, the current capacity data CCD may be updated as 2000. That is, the current capacity data CCD may indicate the most-recently estimated current capacity of the battery cell 111.

In an embodiment, noise may be included in the most-recently estimated current capacity of the battery cell 111, so that the capacity estimating unit 140 may update the current capacity data CCD by referring to both a value of the current capacity data CCD before the update and the most-recently estimated current capacity of the battery cell 111. For example, in a case where the value of the current capacity data CCD before the update is 2000 and the most-recently estimated current capacity is 1900mAh, the current capacity data CCD may be updated as 1950, which is a numerical average of the two values. Instead of the numerical average, a weighted average may be applied thereto.

In another embodiment, the capacity estimating unit 140 updates the current capacity data CCD by using current capacities of the battery cell 111 that is recently estimated at a plurality of times. For example, when the most-recently estimated current capacity is 1910mAh, an estimated current capacity just previous to the most recent estimate is 1870mAh, and a previously estimated current capacity is 1920mAh, the current capacity data CCD may be updated as 1900mAh that is a numerical average of the three values. In an embodiment, instead of the numerical average, a weighted average may be used so that a greater weight may be applied to the most-recently estimated current capacity.

In other embodiments, the first time and the second time may be set so that the difference between the first SOC and the second SOC may be equal to or greater than 36%. When the difference between the first SOC and the second SOC is small, the estimated current capacity of the battery cell 111 may be inaccurate. Thus, when the difference between the first SOC and the second SOC is less than 36%, the second time may be re-determined.

In another embodiment, the capacity estimating unit 140 estimates the current capacity of the battery cell 111 by analyzing a pattern of the cell voltage data VD and the current data CD. The first storage unit 170 may store pattern data on patterns of cell voltage and cell current at different capacities of the battery cell 111. The capacity estimating unit 140 may scan a pattern that is most similar to the pattern of the cell voltage data VD and the current data CD by using the pattern data, and may estimate the current capacity of the battery cell 111 based on a scanning result.

The internal resistance estimating unit 150 generates the current internal resistance data CIRD by estimating the current internal resistance of the battery cell 111 based on the cell voltage data VD and the current data CD. The internal resistance estimating unit 150 may receive the cell voltage data VD and the current data CD from the measuring unit 130, and may estimate the current internal resistance of the battery cell 111 by using the cell voltage data VD and the current data CD. It is known that an internal resistance of the battery cell 111 increases as the battery cell 111 ages.

In an embodiment, the internal resistance estimating unit 150 estimates the current internal resistance of the battery cell 111 based on the cell voltage data VD and the current data CD, by using a fact that a difference between an open circuit voltage and a cell voltage of the battery cell 111 is increased as current output from the battery cell 111 is increased. The current internal resistance of the battery cell 111 may be estimated based on a variation level of the cell voltage at a time at which the current output from the battery cell 111 sharply changes.

In another embodiment, the internal resistance estimating unit 150 determines a fourth time at which current of the battery cell 111 is 0, and then determines a third open circuit voltage that is a cell voltage of the battery cell 111 at the fourth time.

The internal resistance estimating unit 150 may determine a fifth time at which the battery 110 is turned to an SOC or a state of discharge. The fifth time may be as close to (e.g., adjacent to) the fourth time as possible. The fifth time may be set as a time after a period of time (e.g., a predetermined time) elapses from a time at which the battery 110 is turned to the SOC or the state of discharge. When charging or discharging of the battery 110 starts, the cell voltage of the battery cell 111 fluctuates. The period of time (e.g., a predetermined time) may indicate a time period in which the fluctuation of the cell voltage subsides (e.g., disappears) and then the cell voltage is stabilized. The fifth time may be set as a time at which the cell voltage is stabilized after the current of the battery cell 111 becomes greater or less than 0.

The internal resistance estimating unit 150 may estimate the current internal resistance of the battery cell 111 by dividing a difference between a cell voltage of the battery cell 111 in the fifth time and the third open circuit voltage by current of the battery cell 111 in the fifth time.

The internal resistance estimating unit 150 may update the current internal resistance data CIRD by referring to the estimated current internal resistance. The current internal resistance data CIRD may indicate a most-recently estimated current internal resistance of the battery cell 111. In an embodiment, the current internal resistance data CIRD may be determined based on a value of the current internal resistance data CIRD before the update and the most-recently estimated current internal resistance of the battery cell 111 or may be determined based on current internal resistances of the battery cell 111 that is recently estimated at a plurality of times.

In another embodiment, the internal resistance estimating unit 150 estimates the current internal resistance of the battery cell 111 by using the data OSD. As described above, the battery management unit 120 may further include the first storage unit 170 that stores the data OSD.

The internal resistance estimating unit 150 may determine a third time at which current of the battery cell 111 is not 0. At the third time, the battery 110 may be in an SOC or a state of discharge. The internal resistance estimating unit 150 may determine a charging-discharging voltage that is a cell voltage of the battery cell 111 at the third time, and may determine charging-discharging current that is the current of the battery cell 111 at the third time.

The internal resistance estimating unit 150 may determine the SOC of the battery cell 111 at the third time. The internal resistance estimating unit 150 may have information about an SOC at a particular time before the third time. For example, the internal resistance estimating unit 150 may receive information about an SOC at the second time from the capacity estimating unit 140. The internal resistance estimating unit 150 may calculate a varied capacity between the second time and the third time by integrating current of the battery cell 111 between the second time and the third time, and then may determine the SOC at the third time, based on the varied capacity and the current capacity of the battery cell 111 that is estimated by the capacity estimating unit 140.

In an embodiment, because the SOC is 0% at a time at which the battery cell 111 is fully discharged and the SOC is 100% at a time in which the battery cell 111 is fully charged, the internal resistance estimating unit 150 may determine the SOC at the third time by integrating current of the battery cell 111 from after the fully-discharged time or the fully-charged time to the third time.

In another embodiment, the internal resistance estimating unit 150 determines an open circuit voltage that is a cell voltage of the battery cell 111 in a particular time at which current of the battery cell 111 is 0 before the third time, and determines an SOC corresponding to the open circuit voltage, based on the data OSD stored in the first storage unit 170. By doing so, the internal resistance estimating unit 150 may determine the SOC at the particular time. The internal resistance estimating unit 150 may calculate a varied capacity between the particular time and the third time by integrating current of the battery cell 111 between the particular time and the third time, and then may determine the SOC at the third time, based on the varied capacity and the current capacity of the battery cell 111 that is estimated by the capacity estimating unit 140.

The internal resistance estimating unit 150 may determine an open circuit voltage of the battery cell 111 at the third time, which corresponds to the determined SOC at the third time, based on the data OSD stored in the first storage unit 170. The internal resistance estimating unit 150 may estimate the current internal resistance of the battery cell 111 by dividing a difference between the open circuit voltage and the charging-discharging voltage by the charging-discharging current. The internal resistance estimating unit 150 may update the current internal resistance data CIRD by referring to the estimated current internal resistance.

In another embodiment, the internal resistance estimating unit 150 estimates the current internal resistance of the battery cell 111 by analyzing a pattern of the cell voltage data VD and the current data CD. The first storage unit 170 may store pattern data on the patterns of cell voltage and the current according to internal resistances (e.g., at different internal resistances) of the battery cell 111. The internal resistance estimating unit 150 may scan a pattern that is the most similar to the pattern of the cell voltage data VD and the current data CD by using the pattern data, and may estimate the current internal resistance of the battery cell 111, based on a scanning result.

The SOH estimating unit 160 estimates the SOH of the battery cell 111, based on the current capacity data CCD and the current internal resistance data CIRD. The SOH estimating unit 160 receives the current capacity data CCD from the capacity estimating unit 140, receives the current internal resistance data CIRD from the internal resistance estimating unit 150, and then estimates the SOH of the battery cell 111, based on the current capacity data CCD and the current internal resistance data CIRD.

According to an embodiment, the SOH estimating unit 160 includes a fuzzy logic block that receives an input of the current capacity data CCD and the current internal resistance data CIRD and outputs the SOH of the battery cell 111. The fuzzy logic block determines whether the current capacity of the battery cell 111 is good, normal, or bad, based on the current capacity data CCD. The fuzzy logic block also determines whether the current internal resistance of the battery cell 111 is good, normal, or bad, based on the current internal resistance data CIRD. The fuzzy logic block estimates the SOH of the battery cell 111 by applying an If-then rule to a result of determining the current capacity and a result of determining the current internal resistance. Examples of the If-then rule are as below.

If the current capacity is good and the current internal resistance is good, then the SOH of the battery cell 111 is good. Here, the SOH is determined between about 0.9 and about 1.

If the current capacity is good and the current internal resistance is normal, then the SOH of the battery cell 111 is slightly good. Here, the SOH is determined between about 0.7 and about 0.9.

If the current capacity is good and the current internal resistance is bad, then the SOH of the battery cell 111 is normal. Here, the SOH is determined between about 0.5 and about 0.7.

If the current capacity is normal and the current internal resistance is good, then the SOH of the battery cell 111 is slightly good. Here, the SOH is determined between about 0.7 and about 0.9.

If the current capacity is normal and the current internal resistance is normal, then the SOH of the battery cell 111 is normal. Here, the SOH is determined between about 0.5 and about 0.7.

If the current capacity is normal and the current internal resistance is bad, then the SOH of the battery cell 111 is slightly bad. Here, the SOH is determined between about 0.3 and about 0.5.

If the current capacity is bad and the current internal resistance is good, then the SOH of the battery cell 111 is normal. Here, the SOH is determined between about 0.5 and about 0.7.

If the current capacity is bad and the current internal resistance is normal, then the SOH of the battery cell 111 is slightly bad. Here, the SOH is determined between about 0.3 and about 0.5.

If the current capacity is bad and the current internal resistance is bad, then the SOH of the battery cell 111 is slightly bad. Here, the SOH is determined between about 0 and about 0.3.

In another embodiment, the SOH estimating unit 160 estimates the SOH of the battery cell 111 based on the current capacity data CCD and the current internal resistance data CIRD, by using initial capacity data ICD about an initial capacity of the battery cell 111 and initial internal resistance data IIRD about an initial internal resistance of the battery cell 111. The battery management unit 120 may further include a second storage unit 180 that stores the initial capacity data ICD about the initial capacity of the battery cell 111 and the initial internal resistance data IIRD about the initial internal resistance of the battery cell 111. The initial capacity is a capacity of the battery cell 111 according to product specification, which is attributed to (e.g., allocated to) the battery cell 111 at the time of its manufacture. The initial internal resistance indicates an internal resistance that is attributed to (e.g., allocated to) the battery cell 111 at the time of its manufacture.

The SOH estimating unit 160 may estimate a capacity-based SOH of the battery cell 111, according to the initial capacity data ICD and the current capacity data CCD. The capacity-based SOH is referred to as a first SOH.

The SOH estimating unit 160 may include deterioration capacity data DCD about a deterioration capacity that the battery cell 111 has when the battery cell 111 is in a deterioration state. The deterioration capacity may be determined according to a capacity of the battery cell 111, which is guaranteed by a manufacturer of the battery pack 100. When the current capacity of the battery cell 111 is less than the deterioration capacity, the SOH estimating unit 160 may determine that the battery cell 111 has deteriorated. For example, the deterioration capacity may be determined between about 60% and about 90% of the initial capacity. The deterioration capacity data DCD may indicate a ratio of the deterioration capacity to the initial capacity. The first SOH may be determined as a value obtained by dividing a difference between the current capacity and the deterioration capacity of the battery cell 111 by a difference between the initial capacity and the deterioration capacity of the battery cell 111.

The SOH estimating unit 160 may estimate an internal resistance-based SOH of the battery cell 111, according to the initial internal resistance data IIRD and the current internal resistance data CIRD. The internal resistance-based SOH is referred to as a second SOH.

The SOH estimating unit 160 may include deterioration internal resistance data DIRD about a deterioration internal resistance that the battery cell 111 has when the battery cell 111 is in a deterioration state. The battery cell 111 may have the deterioration internal resistance when the current capacity of the battery cell 111 is less than the deterioration capacity. For example, the deterioration internal resistance may be determined between about 130% and about 200% of the initial internal resistance. The deterioration internal resistance data DIRD may indicate a ratio of the deterioration internal resistance to the initial internal resistance. The second SOH may be determined as a value obtained by dividing a difference between the deterioration internal resistance and the current internal resistance of the battery cell 111 by a difference between the deterioration internal resistance and the initial internal resistance of the battery cell 111.

The SOH estimating unit 160 may estimate the SOH of the battery cell 111, based on the first SOH and the second SOH. For example, the SOH of the battery cell 111 may be determined as a numerical average of the first SOH and the second SOH. In another embodiment, the SOH of the battery cell 111 may be determined as a weighted average of the first SOH and the second SOH. According to a capacity of the battery cell 111, a weight of the first SOH and a weight of the second SOH may be adjusted. For example, as the capacity of the battery cell 111 is increased, the weight of the first SOH may be greater than the weight of the second SOH. Conversely, as the capacity of the battery cell 111 is decreased, the weight of the second SOH may be greater than the weight of the first SOH.

As described above, the measuring unit 130 measures the cell voltage and current of the battery cell 111 of the battery pack 100 in operation, and generates the cell voltage data VD and the current data CD in real-time. The capacity estimating unit 140 and the internal resistance estimating unit 150 generate the current capacity data CCD in real-time by estimating the current capacity of the battery cell 111 based on only the cell voltage data VD and the current data CD without using separate additional circuit devices, and generate the current internal resistance data CIRD in real-time by estimating the current internal resistance of the battery cell 111. The SOH estimating unit 160 measures the SOH of the battery cell 111 in real-time, based on the current capacity data CCD and the current internal resistance data CIRD. Thus, the battery pack 100 in operation may accurately estimate the SOH of the battery cell 111 in a relatively easy way.

In embodiments according to FIG. 1, the battery management unit 120 of the battery pack 100 estimates the SOH of the battery cell 111, but in another embodiment, an upper controller or an external controller, which may communicate with the battery pack 100, the measuring unit 130 of the battery pack 100, or the battery management unit 120 of the battery pack 100, estimates the SOH of the battery cell 111.

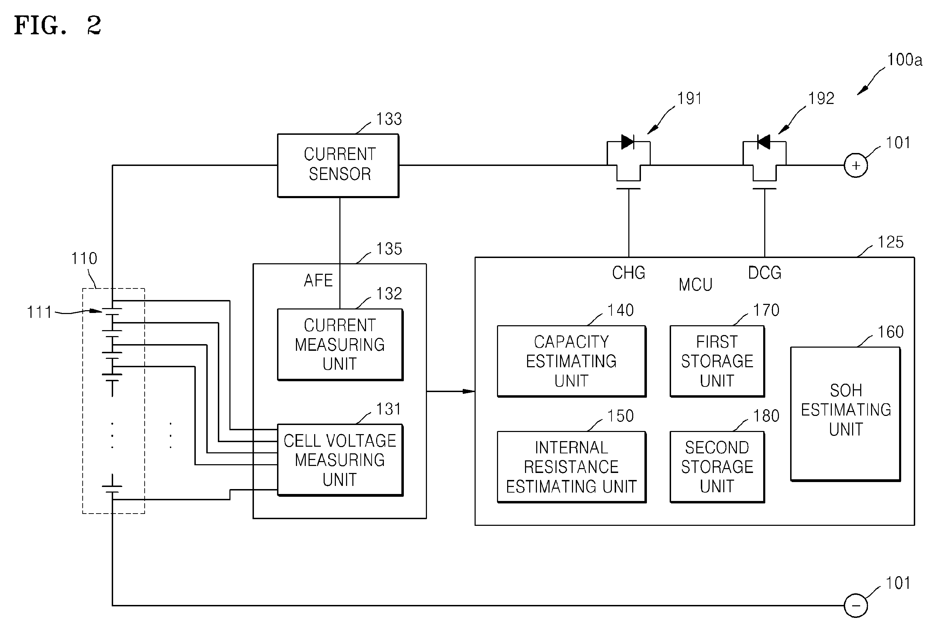

FIG. 2 is a block diagram of a battery pack 100a, according to another embodiment of the present invention.

Referring to FIG. 2, the battery pack 100a includes the battery 110, an AFE 135, and a micro controller unit (MCU) 125.

The battery 110 includes the battery cells 111. Referring to FIG. 2, the battery cells 111 are connected in series, but if desired, the battery cells 111 may be connected in series, in parallel, or in combination of serial and parallel connections. Also, the number of the battery cells may be selected based on (e.g., determined according to) a desired output voltage. The battery cells 111 that are positioned at both ends are connected to the terminals 101.

The AFE 135 may correspond to the measuring unit 130 shown in FIG. 1. The AFE 135 includes a cell voltage measuring unit 131 for measuring a cell voltage of each of the battery cells 111. The cell voltage measuring unit 131 may be coupled to lines that extend from nodes between the terminals 101 and the battery cells 111. The cell voltage measuring unit 131 may measure a cell voltage and may convert the measured cell voltage into cell voltage data by using an ADC. The cell voltage data may be provided to the MCU 125.

The AFE 135 includes a current measuring unit 132 that is coupled to a current sensor 133 for measuring charging-discharging current of the battery cells 111. The current sensor 133 may be a shunt or a hall sensor, which is mounted in a high-current path between the battery 110 and the terminals 101. The current measuring unit 132 may convert an analog current value into current data, wherein the analog current value corresponds to current that is measured by the current sensor 133. The current data may be provided to the MCU 125.

The MCU 125 may monitor a state of the battery 110 and may control all operations including charging and discharging operations by the battery 110. The MCU 125 may receive measurement data from the AFE 135. The measurement data may include the cell voltage data, the current data, temperature data indicating a temperature of the battery 110, terminal voltage data indicating a terminal voltage between the terminals 101, and/or the like. The terminal voltage data may be calculated by the MCU 125 using the cell voltage data.

The MCU 125 may control charging and discharging of the battery 110, based on the measurement data. The MCU 125 may calculate a remaining amount of power, a lifetime, an SOC, and/or the like from a plurality of pieces of measured data, or may determine whether or not an error has occurred in the battery 110. When the error has occurred in the battery 110, the MCU 125 may control a charging switch 191 and/or a discharging switch 192, or may cut a fuse. When the terminal voltage data is greater than a charging upper limit value (e.g., a preset charging upper limit value), the MCU 125 may open the charging switch 191 so as to discontinue charging, and when the terminal voltage data is less than a discharging lower limit value (e.g., preset discharging lower limit value), the MCU 125 may open the discharging switch 192 so as to discontinue discharging. When the current data is greater than an over-current reference value (e.g., a preset over-current reference value), the MCU 125 may cut the fuse so as to protect the battery pack 100.

The MCU 125 measures an SOH of each of the battery cells 111, based on the cell voltage data and the current data. The MCU 125 includes the capacity estimating unit 140, the internal resistance estimating unit 150, and the SOH estimating unit 160 shown in FIG. 1.

The MCU 125 may include the first storage unit 170 and the second storage unit 180 shown in FIG. 1. The first storage unit 170 and the second storage unit 180 may be non-volatile memory devices such as an electrically erasable programmable read-only memory (EEPROM), a flash memory, a ferroelectric RAM (FeRAM), a magnetoresistive random-access memory (MRAM), a phase-change memory (PRAM), and/or the like. Although the first storage unit 170 and the second storage unit 180 are illustrated as separate elements, the first storage unit 170 and the second storage unit 180 may be included in one memory device.

The MCU 125 may communicate with an external device and may transmit the SOH of each of the battery cells 111 to the external device.

Referring to FIG. 2, the battery pack 100a includes the AFE 135 and the MCU 125 as separate elements, but the AFE 135 and the MCU 125 may be integrated in one chip. Further, although the MCU 125 is illustrated as one micro-controller chip, functions of the MCU 125 may be embodied as at least two integrated circuit chips. Furthermore, in an embodiment where the battery pack 100a has a hierarchical structure in which a battery module includes a plurality of battery cells, a battery tray includes a plurality of the battery modules, a battery rack includes a plurality of the battery trays, and a battery system includes a plurality of the battery racks, a method of estimating an SOH of a battery cell may be performed by a tray management unit for managing and controlling the battery tray, a rack management unit for managing and controlling the battery rack, and/or a system management unit for managing and controlling the battery system. For example, the system management unit may estimate an SOH of each of the battery cells, based on cell voltage data and current data of each of the battery cells included in the battery system. If there is a monitoring system capable of communicating with the battery system, the monitoring system may estimate the SOH of each of the battery cells.

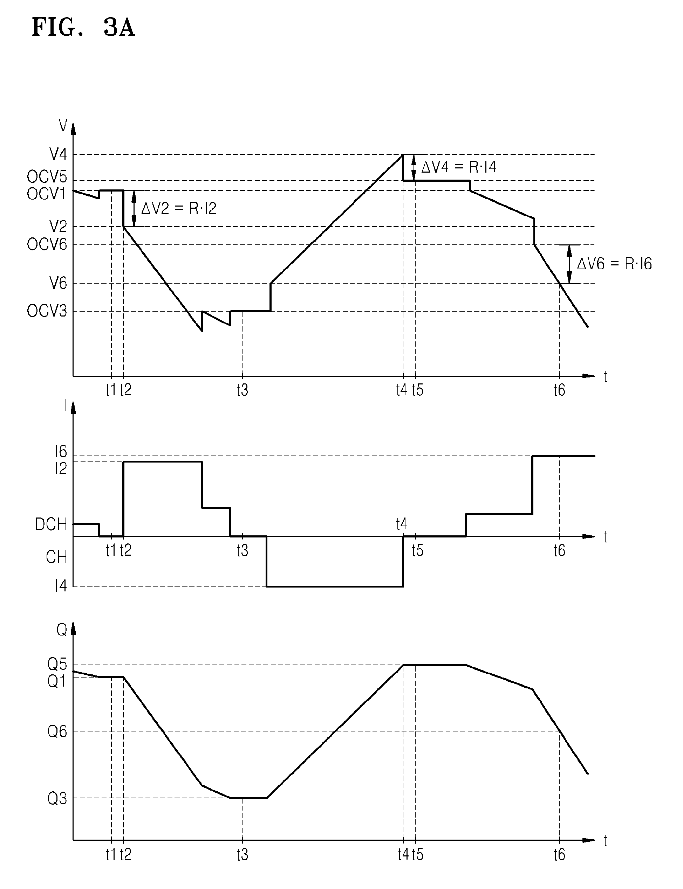

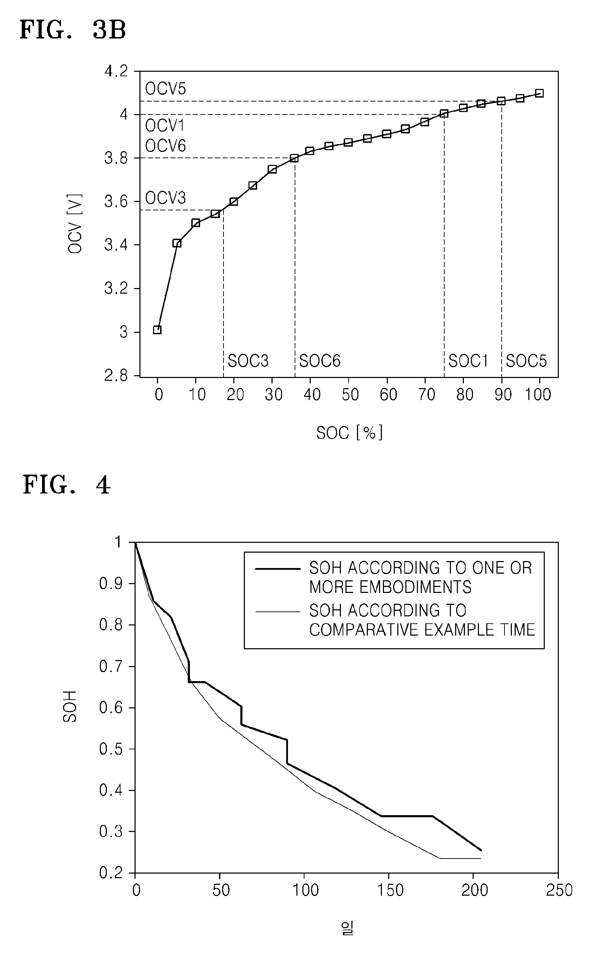

FIG. 3A illustrates graphs indicating a voltage, current, and a remaining capacity of the battery cell 111, according to an embodiment of the present invention. FIG. 3B illustrates a graph indicating a correlation between an open circuit voltage and an SOC of the battery cell 111, according to an embodiment of the present invention. With reference to FIGS. 1, 3A, and 3B, a method of estimating a current capacity and a current internal resistance of the battery cell 111 according to an embodiment will now be described.

The voltage graph of FIG. 3A indicates the cell voltage data VD of FIG. 1 as a function of time, and the current graph of FIG. 3A indicates the current data CD of FIG. 1 as a function of time. The current graph of FIG. 3A indicates discharging current of the battery cell 111, and a negative current value indicates that the battery cell 111 is being charged. The voltage graph and the current graph of FIG. 3A are shown in relation to the method of estimating a current capacity and a current internal resistance of the battery cell according to an embodiment. The bottom graph of FIG. 3A indicates a remaining capacity of the battery cell 111 as a function of time, wherein the remaining capacity is calculated by integrating current of the battery cell 111, based on the current data CD. FIG. 3B illustrates a graph indicating the correlation between the open circuit voltage and the SOC of the battery cell 111 as stored as the data OSD in the first storage unit 170 shown in FIG. 1.

First, the method of estimating the current capacity of the battery cell 111 is described below.

A time when current of the battery cell 111 is 0 includes a first time t1, a third time t3, and a fifth time t5. In order to estimate a current capacity between the first time t1 and the third time t3 in which the battery cell 111 is discharged, a cell voltage of the first time t1 is determined as a first open circuit voltage OCV1 and a cell voltage of the third time t3 is determined as a third open circuit voltage OCV3. A varied capacity between the first time t1 and the third time t3 may be calculated by integrating current between the first time t1 and the third time t3. Referring to the bottom graph of FIG. 3A, which is a capacity graph, the varied capacity may be calculated as a difference (Q1-Q3) between a remaining capacity Q1 at the first time t1 and a remaining capacity Q3 at the third time t3. Referring to the graph of FIG. 3B, an SOC at the first time t1 corresponding to the first open circuit voltage OCV1 is SOC1, and an SOC at the third time t3 corresponding to the third open circuit voltage OCV3 is SOC3. The current capacity of the battery cell 111, which is calculated based on cell voltage data DV and current data CV between the first time t1 and the third time t3, may be determined as (Q1-Q3)/(SOC1-SOC3).

A current capacity of the battery cell 111 may be estimated between the third time t3 and the fifth time t5 in which the battery cell 111 is discharged. A cell voltage at the fifth time t5 is determined as a fifth open circuit voltage OCV5, and referring to the graph of FIG. 3B, an SOC at the fifth time t5 corresponding to the fifth open circuit voltage OCV5 is SOC5. A varied capacity between the third time t3 and the fifth time t5 may be calculated by integrating current between the third time t3 and the fifth time t5. Referring to the capacity graph, the varied capacity may be calculated as a difference (Q5-Q3) between the remaining capacity Q3 at the third time t3 and a remaining capacity Q5 at the fifth time t5. The current capacity of the battery cell 111, which is calculated based on cell voltage data DV and current data CV between the third time t3 and the fifth time t5, may be determined as (Q5-Q3)/(SOC5-SOC3).

A current capacity of the battery cell 111 may be estimated when the battery cell 111 is being charged, being discharged, or when the battery cell 111 is being sequentially charged and discharged. That is, the current capacity of the battery cell 111 may be estimated between the first time t1 and the fifth time t5. However, because a difference between the SOC at the first time t1 (i.e., SOC1) and the SOC at the fifth time t5 (i.e., SOC5) is small, the current capacity of the battery cell 111, which is estimated between the first time t1 and the fifth time t5, may be inaccurate. However, when the difference between the SOC at the first time t1 (i.e., SOC1) and the SOC at the fifth time t5 (i.e., SOC5) is equal to or greater than a reference value (e.g., a predetermined value), e.g., 36%, the current capacity of the battery cell 111, which is estimated between the first time t1 and the fifth time t5, may have sufficient reliability.

Hereinafter, the method of estimating the current internal resistance of the battery cell 111 is described below. As an example, it is assumed that a current internal resistance of the battery cell 111 is estimated at each of a second time t2 and a fourth time t4 that are times when current of the battery cell 111 is not 0.

At the second time t2, the current of the battery cell 111 is greater than 0, but a SOC of the battery cell 111 is constant between the first time t1 and the second time t2. Although a cell voltage of the battery cell 111 fluctuates at the second time t2 at which discharging starts before the cell voltage is stabilized, FIG. 3A does not show the fluctuation. The second time t2 may be selected as a time when the fluctuation disappears and the cell voltage is stabilized. A cell voltage at the second time t2 is determined as a charging-discharging voltage V2, and current at the second time t2 is determined as charging-discharging current I2. In another embodiment, the second time t2 may be defined as a time period, and the cell voltage and the current may be respectively defined as an average of cell voltages and an average of currents during the time period. Because a SOC at the second time t2 is equal to the SOC at the first time t1, an open circuit voltage at the second time t2 is equal to the first open circuit voltage OCV1 at the first time t1. A current internal resistance of the battery cell 111, which is estimated at the second time t2, may be determined as (OCV1-V2)/12.

Similarly, a current internal resistance of the battery cell 111 may be estimated at the fourth time t4. The current internal resistance of the battery cell 111, which is estimated at the fourth time t4, may be determined as (V4-OCV5)/14. Although I4 is a negative number, a value of a current internal resistance is always a positive number, thus, even when the value of the current internal resistance is a negative number, the value of the current internal resistance may be expressed as (e.g., recorded as) a positive number. Similarly, a current internal resistance of the battery cell 111 may be estimated when charging is started or discharging is ended.

Hereinafter, according to another embodiment, a method of estimating a current internal resistance of the battery cell 111 is described below. As an example, it is assumed that the current internal resistance of the battery cell 111 is estimated at a sixth time t6.

A cell voltage at the sixth time t6 is determined as a charging-discharging voltage V6, and current at the sixth time t6 is determined as charging-discharging current I6. As described above, the SOC of the battery cell 111 at the fifth time t5 is SOC5, and the internal resistance estimating unit 150 may obtain information indicating that the SOC of the battery cell 111 at the fifth time t5 is SOC5 in the same manner as the capacity estimating unit 140, or may receive, from the capacity estimating unit 140, the information indicating that the SOC of the battery cell 111 at the fifth time t5 is SOC5. A varied capacity between the fifth time t5 and the sixth time t6 may be calculated by integrating current between the fifth time t5 and the sixth time t6, and referring to the capacity graph, the varied capacity may be calculated as a difference (Q5-Q6) between the remaining capacity Q5 at the fifth time t5 and a remaining capacity Q6 at the sixth time t6. An SOC at the sixth time t6 may be determined based on the calculated varied capacity. SOC6, that is, the SOC of the battery cell 111 at the sixth time t6 may be calculated as SOC5 - (Q5-Q6)/current capacity. Referring to the graph of FIG. 3B, a sixth open circuit voltage OCV6 at the sixth time t6, which corresponds to the SOC (SOC6) at the sixth time t6, may be determined. The current internal resistance of the battery cell 111, which is estimated at the sixth time t6, may be determined as (OCV6-V6)/I6.

As described with reference to the aforementioned methods, the current capacity and the current internal resistance of the battery cell 111 may be estimated based on the cell voltage data VD and the current data CD, and the data OSD on the correlation between the open circuit voltage and the SOC of the battery cell 111.

FIG.4 illustrates a graph of an SOH estimated according to the one or more embodiments and an SOH estimated according to a comparative example.

The SOH according to the comparative example is an SOH of a battery cell that was calculated based on a capacity of the battery cell, which was measured by integrating current flowing into the battery cell while the fully discharged battery cell was being charged. As shown in the graph, the SOH of the battery cell is decreased over time.

The SOH according to the one or more embodiments is an SOH of a battery cell, which is estimated in a manner such that a current capacity and a current internal resistance of the battery cell is estimated based on the cell voltage data VD and the current data CD, and then the SOH of the battery cell is estimated based on the estimated current capacity and current internal resistance. As shown in FIG. 4, the SOH of the battery cell according to the one or more embodiments also decreases over time, and has a result similar to a result of the SOH according to the comparative example.

The SOH estimation according to the comparative example requires full discharging and full charging processes, such that it is difficult to apply the SOH estimation according to the comparative example to a battery pack in operation. However, the SOH estimation according to the one or more embodiments may be applied to a battery pack in operation, does not require an additional circuit device, and may be easily performed. Further, as shown in FIG. 4, the SOH result by the SOH estimation according to the one or more embodiments is similar to the SOH result by the SOH estimation according to the comparative example, thus, the SOH estimation according to the one or more embodiments may have sufficient reliability.

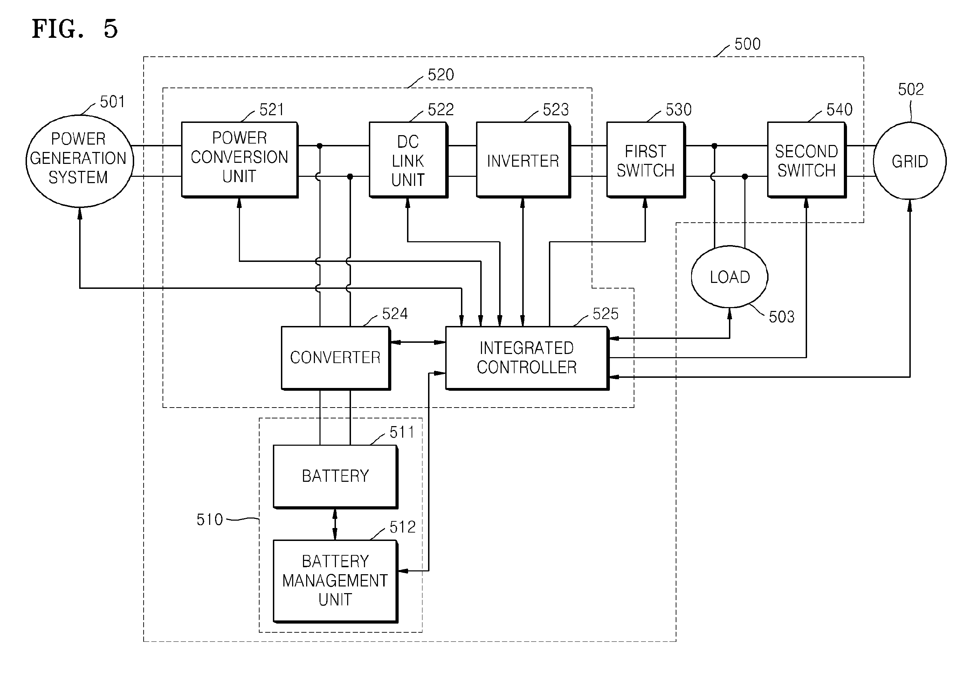

FIG. 5 is a block diagram of an energy storage device 500 including a battery pack 510, according to an embodiment of the present invention.

Referring to FIG. 5, the energy storage device 500 is in conjunction with a power generation system 501 and a grid 502, thereby supplying power to a load 503. The energy storage device 500 may be referred to as an energy storage system.

The power generation system 501 generates power from an energy source. The power generation system 501 may supply the generated power to the energy storage device 500. The power generation system 501 may include, but is not limited to, at least one of a photovoltaic generation system, a wind power generation system, or a tidal power generation system. All types of power generation systems that generate power by using renewable energy such as solar heat or terrestrial heat may be included in the power generation system 501. In particular, a solar cell that generates power by using solar light may be easily mounted in a house or a factory, so that the solar cell may be used with the energy storage device 500 in the house or the factory. The power generation system 501 may configure a large capacity energy system in which a plurality of power generation modules capable of generating power is arrayed in parallel.

The grid 502 may include a power generation plant, a substation, a power transmission line, and/or the like. When the grid 502 is in a normal state, the grid 502 may supply power to the energy storage device 500, i.e., at least one of the load 503 and the battery pack 510, or may receive power from the energy storage device 500, in particular, the battery pack 510 or the power generation system 501. When the grid 502 is in an abnormal state, power transmission between the grid 502 and the energy storage device 500 is discontinued.

The load 503 may consume power generated by the power generation system 501, power stored in the battery pack 510, and/or power received from the grid 502. Electric devices in the house or the factory may be examples of the load 503.

The energy storage device 500 may store power, which is generated by the power generation system 501, in the battery pack 510 or may supply the power to the grid 502. The energy storage device 500 may supply power stored in the battery pack 510 to the grid 502, or may store power, which is received from the grid 502, in the battery pack 510. Further, when the grid 502 is in the abnormal state, e.g., when a power supply failure occurs, the energy storage device 500 may perform an uninterruptible power supply (UPS) function so that the energy storage device 500 may supply power generated by the power generation system 501 or power stored in the battery pack 510 to the load 503.

In one embodiment, the energy storage device 500 includes a power conversion system (PCS) 520, the battery pack 510, a first switch 530, and a second switch 540. The PCS 520 may be referred to as a power conversion device.

The PCS 520 may convert power, which is supplied by the power generation system 501, the grid 502, and/or the battery pack 510, into power in an appropriate form and may supply the power to the load 503, the battery pack 510, and/or the grid 502. The PCS 520 may include a power conversion unit 521, a direct current (DC) link unit 522, an inverter 523, a converter 524, and an integrated controller 525.

The power conversion unit 521 may be coupled between (e.g., connected between) the power generation system 501 and the DC link unit 522. The power conversion unit 521 may convert power, which is generated by the power generation system 501, into a DC link voltage and may transmit it to the DC link unit 522. The power conversion unit 521 may include a power conversion circuit such as a converter circuit, a rectifying circuit, and/or the like, depending on types of the power generation system 501. For example, in an embodiment in which the power generation system 501 generates DC power, the power conversion unit 521 includes a DC-DC converter circuit for converting the DC power generated by the power generation system 501 into another DC power. In an embodiment in which the power generation system 501 generates alternating current (AC) power, the power conversion unit 521 includes the rectifying circuit for converting the AC power into DC power.

In an embodiment in which the power generation system 501 is a photovoltaic generation system, the power conversion unit 521 includes a maximum power point tracking (MPPT) converter for performing an MPPT control so as to maximally obtain power generated by the power generation system 501, according to variation of solar radiation, temperature, and/or the like. When the power generation system 501 does not generate power, the power conversion unit 521 discontinues its operation, so that power consumed by a power conversion device such as the converter or the rectifying circuit may be minimized or decreased.

Due to problems such as an instantaneous voltage-drop in the power generation system 501 or the grid 502, and occurrence of a peak load in the load 503, a level of a DC link voltage may be unstable. However, it is desired to stabilize the DC link voltage so as to normally operate the converter 524 and the inverter 523. The DC link unit 522 may be coupled between the power conversion unit 521 and the inverter 523 and may constantly or substantially constantly maintain the DC link voltage. An example of the DC link unit 522 may include a large-capacity capacitor.

The inverter 523 may be a power conversion device coupled between the DC link unit 522 and the first switch 530. The inverter 523 may include an inverter that converts a DC link voltage, which is output from at least one of the power generation system 501 and the battery pack 510, into an AC voltage of the grid 502 and outputs the AC voltage. Additionally, in order to store power of the grid 502 in the battery pack 510 during a charging mode, the inverter 523 may include a rectifying circuit that converts an AC voltage from the grid 502 into a DC voltage and then outputs a DC link voltage. The inverter 523 may be a bidirectional inverter in which a direction of an input and an output may be changed.

The inverter 523 may include a filter to remove harmonics from an AC voltage that is output to the grid 502. Further, in order to suppress or limit occurrence of reactive power, the inverter 523 may include a phase lock loop (PLL) to synchronize a phase of an AC voltage output from the inverter 523 with a phase of an AC voltage of the grid 502. Furthermore, the inverter 523 may function to limit a voltage variation range, to improve a power factor, to remove a DC component, and to protect or decrease a transient phenomenon.

The converter 524 may be a power conversion device coupled between the DC link unit 522 and the battery pack 510. The converter 524 may include a DC-DC converter that converts (e.g., DC-DC converts) a DC voltage of power stored in the battery pack 510 into a DC link voltage with an appropriate level and outputs it to the inverter 523 during a discharging mode. The converter 524 may include a DC-DC converter that converts (e.g., DC-DC converts) a voltage of power output from the power conversion unit 521 or from the inverter 523 into a voltage with an appropriate level, i.e., a charging voltage level that is requested by the battery pack 510, and then outputs the voltage to the battery pack 510 during a charging mode. The converter 524 may be a bidirectional converter in which a direction of an input and an output may be changed. When charging or discharging with respect to the battery pack 510 is not performed, the converter 524 discontinues its operation, so that power consumption may be minimized or decreased.

The integrated controller 525 may monitor states of the power generation system 501, the grid 502, the battery pack 510, and the load 503. For example, the integrated controller 525 may monitor a number of operational parameters, such as, whether or not a power supply failure occurs in the grid 502, whether or not power is generated by the power generation system 501, an amount of generated power when the power generation system 501 generates power, an SOC of the battery pack 510, an amount of power consumption by the load 503, a time, and/or the like.

According to monitoring results and a suitable algorithm (e.g., a preset algorithm), the integrated controller 525 may control operations of the power conversion unit 521, the inverter 523, the converter 524, the first switch 530, and the second switch 540. For example, when a power supply failure occurs in the grid 502, the integrated controller 525 may control power stored in the battery pack 510 or generated by the power generation system 501 to be supplied to the load 503. In a case where sufficient power cannot be supplied to the load 503, the integrated controller 525 may assign priority order to (or set priority orders of) the electric devices of the load 503 and may control the load 503 to supply power to the electric devices having high priority orders. The integrated controller 525 may further control charging and discharging of the battery pack 510.

The first switch 530 and the second switch 540 are connected in series between the inverter 523 and the grid 502, and control a flow of current between the power generation system 501 and the grid 502 by performing an ON or OFF operation in response to a control by the integrated controller 525. According to states of the power generation system 501, the grid 502, and the battery pack 510, the ON or OFF state of the first switch 530 and the second switch 540 may be determined. In more detail, when power from at least one of the power generation system 501 and the battery pack 510 is supplied to the load 503, or power from the grid 502 is supplied to the battery pack 510, the first switch 530 is turned ON. When power from at least one of the power generation system 501 and the battery pack 510 is supplied to the grid 502, or power from the grid 502 is supplied to at least one of the load 503 and the battery pack 510, the second switch 540 is turned ON.

When a power supply failure occurs in the grid 502, the second switch 540 is turned OFF and the first switch 530 is turned ON. By doing so, it is possible to supply power from at least one of the power generation system 501 and the battery pack 510 to the load 503 and simultaneously to prevent power, which is supplied to the load 503, from flowing toward the grid 502. As described above, the energy storage device 500 operates as a stand-alone system, so that it is possible to prevent an accident in which a person working near a power cable of the grid 502 receives an electric shock from the power generation system 501 or the battery pack 510.

The first switch 530 and the second switch 540 may include a switching device such as a relay capable of enduring or processing high current.

The battery pack 510 may store power after receiving the power from at least one of the power generation system 501 and the grid 502, and may supply stored power to at least one of the load 503 and the grid 502. The battery pack 510 may include a part for storing power and another part for controlling and protecting the part. Charging and discharging of the battery pack 510 may be controlled by the integrated controller 525.

The battery pack 510 may correspond to the battery packs 100 and 100a described with reference to FIGS. 1 and 2. The battery pack 510 includes a battery 511 including at least one battery cell, and a battery management unit 512 for controlling charging and discharging of the battery 511. The battery management unit 512 may include a measuring unit for generating cell voltage data and current data by measuring a cell voltage and current of the battery cell; a capacity estimating unit for generating current capacity data by estimating a current capacity of the battery cell based on the cell voltage data and the current data; an internal resistance estimating unit for generating current internal resistance data by estimating a current internal resistance of the battery cell based on the cell voltage data and the current data; and an SOH estimating unit for estimating an SOH of the battery cell based on the current capacity data and the current internal resistance data. The battery management unit 512 may provide the estimated SOH of the battery cell to the integrated controller 525.

In another embodiment, the battery management unit 512 generates cell voltage data and current data by measuring a cell voltage and current of the battery cell and transmits the cell voltage data and the current data to the integrated controller 525. The integrated controller 525 may receive the cell voltage data and the current data from the battery management unit 512. The integrated controller 525 may include a capacity estimating unit for generating current capacity data by estimating a current capacity of the battery cell based on the cell voltage data and the current data; an internal resistance estimating unit for generating current internal resistance data by estimating a current internal resistance of the battery cell based on the cell voltage data and the current data; and an SOH estimating unit for estimating an SOH of the battery cell based on the current capacity data and the current internal resistance data.

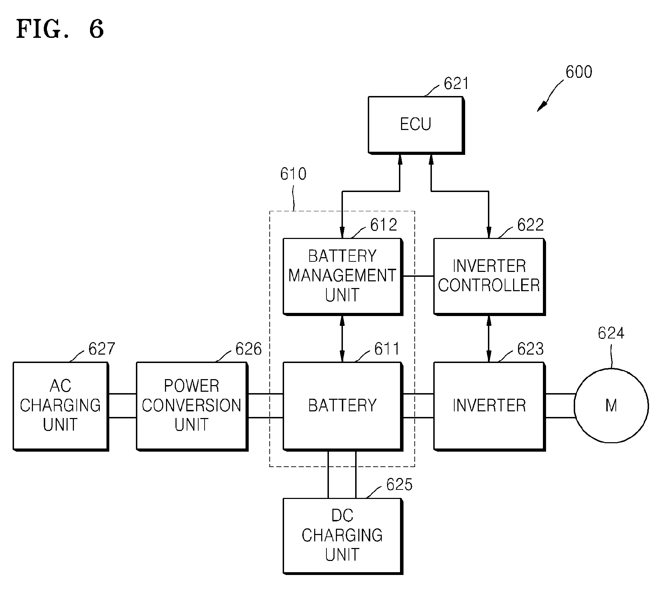

FIG. 6 is a block diagram of an electric vehicle 600 including a battery pack 610, according to an embodiment of the present invention.

Referring to FIG. 6, the electric vehicle 600 may include an electronic control unit (ECU) 621, an inverter controller 622, an inverter 623, a motor 624, and the battery pack 610. The battery pack 610 includes a battery 611 including at least one battery cell, and a battery management unit 612 for controlling charging and discharging of the battery 611. The battery pack 610 may correspond to the battery packs 100 and 100a described with reference to FIGS. 1 and 2.

The battery 611 may include at least one battery cell, may support an output power of the motor 624 by supplying a voltage to the motor 624 in driving the electric vehicle 600, and may recover and store regenerative braking energy of the motor 624 that operates as a power generator in braking the electric vehicle 600. The battery 611 may be charged with DC power supplied from a DC charging unit 625 such as a PCS or an energy storage system of a power supply station. The battery 611 may be charged with AC power supplied from an AC charging unit 627 such as a commercial power source. To do so, the electric vehicle 600 may include a power conversion unit 626. The battery 611 may be coupled to the power conversion unit 626, and the power conversion unit 626 may convert the AC power supplied from the AC charging unit 627 into DC power.

The battery management unit 612 may detect information including a voltage, current, temperature, and/or the like of the battery 611, may diagnose and manage an SOC of the battery 611, and may control all operations such as charging and discharging of the battery 611. The battery management unit 612 may provide information such as a voltage, current, temperature, an SOC, diagnosis information, and/or the like of the battery 611 to the ECU 621 via a communication line, for example, a Controller Area Network (CAN) communication line of the electric vehicle 600.

The battery management unit 612 may include a measuring unit for generating cell voltage data and current data by measuring a cell voltage and current of the battery cell; a capacity estimating unit for generating current capacity data by estimating a current capacity of the battery cell based on the cell voltage data and the current data; an internal resistance estimating unit for generating current internal resistance data by estimating a current internal resistance of the battery cell based on the cell voltage data and the current data; and an SOH estimating unit for estimating an SOH of the battery cell based on the current capacity data and the current internal resistance data. The battery management unit 612 may provide the estimated SOH of the battery cell to the ECU 621.

In another embodiment, the battery management unit 612 generates cell voltage data and current data by measuring a cell voltage and current of the battery cell and transmits the cell voltage data and the current data to the ECU 621. The ECU 621 may receive the cell voltage data and the current data from the battery management unit 612. The ECU 621 may include a capacity estimating unit for generating current capacity data by estimating a current capacity of the battery cell based on the cell voltage data and the current data; an internal resistance estimating unit for generating current internal resistance data by estimating a current internal resistance of the battery cell based on the cell voltage data and the current data; and an SOH estimating unit for estimating an SOH of the battery cell based on the current capacity data and the current internal resistance data.

The ECU 621 generally controls a vehicle state, a driving mode, and/or the like of the electric vehicle 600, and helps a driver to stably drive the electric vehicle 600, in consideration of information about the battery 611 that is provided from the battery management unit 612. When an SOH of one of the battery cells of the battery 611 are equal to or less than a reference value (e.g., a preset reference value), the ECU 621 may identify (e.g., display) the deteriorating battery cell and/or display the SOH thereof to a manager of the electric vehicle 600. The manager may take action such as replacement of the deteriorating battery cell and/or the like, so that the electric vehicle 600 may be driven safely. The ECU 621 may control the inverter 623 via the inverter controller 622. The inverter 623 may provide AC power for driving the motor 624, by converting DC power supplied from the battery 611 into the AC power. Further, when the electric vehicle 600 brakes, the inverter 623 may convert AC power supplied from the motor 624 into DC power and may provide the DC power to the battery 611.

While FIG. 6 illustrates the electric vehicle 600 including the battery pack according to the one or more embodiments, the battery pack may be applied to various other vehicles such as hybrid vehicles, electric bicycles, electric motorbikes, and/or the like.

As described above, according to the one or more embodiments of the present invention, an SOH of a battery cell may be measured by using a cell voltage and current of the battery cell in a simple and cost-effective manner without using an additional circuit or a complicated algorithm. According to the test results, the measurement result of the SOH of the battery cell may be reliable. In addition, a cell voltage and current of a battery cell that is being discharged to a load or that is being charged by a charging device may be measured, so that an SOH of the battery cell in operation may be measured in real-time without separating the battery cell from the load or the charging device.

It is clear for a person skilled in the art that the disclosed embodiments can also be combined where possible.

## Claims

1. A battery pack (100) comprising:
a battery (110) coupled to a load and a charging device, and comprising at least one battery cell (111); and
a battery management unit (120) configured to control charging of the battery (110) from the charging device and discharging of the battery (110) to the load,
wherein the battery management unit (120) comprises:
a measuring unit (130) configured to generate cell voltage data (VD) and current data (CD) by measuring a cell voltage and a current of the at least one battery cell (111);
a capacity estimating unit (140) configured to generate current capacity data (CCD) by estimating a current capacity of the at least one battery cell based on the cell voltage data (VD) and the current data (CD);
an internal resistance estimating unit (150) configured to generate current internal resistance data (CIRD) by estimating a current internal resistance of the at least one battery cell (111) based on the cell voltage data (VD) and the current data (CD); and
a state of health (SOH) estimating unit (160) configured to estimate an SOH of the at least one battery cell (111) based on the current capacity data (CCD) and the current internal resistance data (CIRD).

2. The battery pack of claim 1, further comprising a first storage unit (170) for storing first data on a correlation between an open circuit voltage and a state of charge (SOC) of the at least one battery cell (111), and/or
a second storage unit (180) for storing initial capacity data (ICD) on an initial capacity of the at least one battery cell (111) and initial internal resistance data (IIRD) on an initial internal resistance of the at least one battery cell (111).

3. The battery pack of claim 2, wherein the capacity estimating unit (140) is configured to:
store a first open circuit voltage that is a cell voltage of the at least one battery cell (111) at a first time when the current of the at least one battery cell (111) is 0;
store a second open circuit voltage that is a cell voltage of the at least one battery cell at a second time when the current of the at least one battery cell (111) is 0;
calculate a varied capacity between the first time and the second time by integrating the current of the at least one battery cell from the first time to the second time;
obtain a first SOC corresponding to the first open circuit voltage and a second SOC corresponding to the second open circuit voltage, based on the first data; and
measure the current capacity of the at least one battery cell by dividing the varied capacity by a difference between the first SOC and the second SOC, and updates the current capacity data.

4. The battery pack of claim2 or 3, wherein the internal resistance estimating unit (150) is configured to:
store a charging-discharging voltage that is a cell voltage of the at least one battery cell at a third time when the current of the at least one battery cell (111) is not 0;
store charging-discharging current that is the current of the at least one battery cell (111) at the third time;
obtain an open circuit voltage of the at least one battery cell corresponding to an SOC of the at least one battery cell at the third time, based on the first data; and
estimate the current internal resistance of the at least one battery cell (111) by dividing a difference between the open circuit voltage and the charging-discharging voltage by the charging-discharging current; and
update the current internal resistance data based on the estimated current internal resistance of the at least one battery cell (111).

5. The battery pack of one of claims1 to 4, wherein the internal resistance estimating unit (150) is configured to:
store a third open circuit voltage that is a cell voltage of the at least one battery cell (111) at a fourth time when current of the at least one battery cell is 0; and
estimate the current internal resistance of the at least one battery cell by dividing a difference between a cell voltage of the at least one battery cell (111) at a fifth time, near the fourth time, when current of the at least one battery cell (111) is not 0 and the third open circuit voltage by current of the at least one battery cell (111) at the fifth time; and
update the current internal resistance data based on the estimated current internal resistance of the at least one battery cell (111).

6. The battery pack of one of claims 2 to 5, wherein the SOH estimating unit (160) is configured to measure a first SOH of the at least one battery cell (111), based on the initial capacity data (ICD) and the current capacity data (CCD), and/or
the SOH estimating unit (160) is configured to estimate a second SOH of the at least one battery (111) cell based on the initial internal resistance data (IIRD) and the current internal resistance data.

7. The battery pack of claim 6, wherein the SOH estimating unit comprises deterioration capacity data on a deterioration capacity of the at least one battery cell when the at least one battery cell is in a deterioration state, and
wherein the first SOH is calculated by dividing a difference between the current capacity and the deterioration capacity of the at least one battery cell by a difference between the initial capacity and the deterioration capacity of the at least one battery cell.

8. The battery pack of claim 6 or 7, wherein the SOH estimating unit comprises deterioration internal resistance data on a deterioration internal resistance of the at least one battery cell when the at least one battery cell is in a deterioration state, and
wherein the second SOH is calculated by dividing a difference between the deterioration internal resistance and the current internal resistance of the at least one battery cell by a difference between the deterioration internal resistance and the initial internal resistance of the at least one battery cell.

9. The battery pack of claim 6, wherein the SOH estimating unit is configured toestimate the SOH of the at least one battery cell, based on the first SOH and the second SOH.

10. An energy storage device comprising
a battery pack according to one of claims 1 to 9;
a power conversion device coupled between the battery pack and at least one of a power generation system, a load, and a grid,
wherein the power conversion device is configured to convert electric energy between the battery pack and at least one of the power generation system, the load, and the grid.

11. An electric vehicle comprising:
a battery pack according to one of claims 1 to 9; and
a motor which is driven by using electric energy stored in the battery pack.

12. A method of managing a battery pack comprising a battery and a battery management unit for controlling charging and discharging of the battery, the battery comprising at least one battery cell, the method comprising:
generating cell voltage data and current data by measuring a cell voltage and a current of the at least one battery cell;
generating current capacity data by estimating a current capacity of the at least one battery cell based on the cell voltage data and the current data;
generating current internal resistance data by estimating a current internal resistance of the at least one battery cell based on the cell voltage data and the current data; and
estimating a state of health (SOH) of the at least one battery cell based on the current capacity data and the current internal resistance data.

13. The method of claim 12, further comprising storing first data on a correlation between an open circuit voltage and a state of charge (SOC) of the at least one battery cell, wherein the generating of the current capacity data comprises:
obtaining a first open circuit voltage that is a cell voltage of the at least one battery cell at a first time when the current of the at least one battery cell is 0;
obtaining a second open circuit voltage that is a cell voltage of the at least one battery cell at a second time when the current of the at least one battery cell is 0;
calculating a varied capacity between the first time and the second time by integrating the current of the at least one battery cell from the first time to the second time;
obtaining a first SOC corresponding to the first open circuit voltage and a second SOC corresponding to the second open circuit voltage, based on the first data; and
estimating the current capacity of the at least one battery cell by dividing the varied capacity by a difference between the first SOC and the second SOC.

14. The method of claim 12 or 13, further comprising storing first data on a correlation between an open circuit voltage and a state of charge (SOC) of the at least one battery cell, wherein the generating of the current internal resistance data comprises:
storing a charging-discharging voltage that is a cell voltage of the at least one battery cell at a third time when the current of the at least one battery cell is not 0;
storing charging-discharging current that is the current of the at least one battery cell at the third time;
obtaining an open circuit voltage of the at least one battery cell corresponding to an SOC of the at least one battery cell at the third time, based on the first data; and
estimating the current internal resistance of the at least one battery cell by dividing a difference between the open circuit voltage and the charging-discharging voltage by the charging-discharging current.

15. The method of one of claims 12 to 14, wherein the estimating of the SOH comprises:
estimating a first SOH of the at least one battery cell, based on initial capacity data on an initial capacity of the at least one battery cell and the current capacity data;
estimating a second SOH of the at least one battery cell, based on initial internal resistance data on an initial internal resistance of the at least one battery cell and the current internal resistance data; and
estimating the SOH of the at least one battery cell, based on the first SOH and the second SOH.
